(19)

Europäisches
Patentamt
European
Patent Office
Office européen
des brevets

(11) **EP 1 643 258 B1**

(12) **EUROPEAN PATENT SPECIFICATION**

(45) Date of publication and mention
of the grant of the patent:
**16.12.2009 Bulletin 2009/51**

(51) Int Cl.:
***G01R 31/317*** *(2006.01)*

(21) Application number: **05255893.9**

(22) Date of filing: **22.09.2005**

(54) **Pattern identification and bit level measurements on repetitive patterns**

Signalmustererkennung und Bitniveaumessungen an sich wiederholenden Signalmustern

Identification de motif de signaux et mesure de niveau de bit pour des motifs répétés

(84) Designated Contracting States:
**DE FR GB IT**

(72) Inventors:
• **Kayal, Saumitra**
**Marathahalli, Karnataka 560037 (IN)**
• **Ajgaonkar; of, Manisha**
**Bangalore, Karnataka 560071 (IN)**

(30) Priority: **24.09.2004 US 612880 P**
**02.08.2005 US 196771**

(74) Representative: **Burke, Steven David et al**
**R.G.C. Jenkins & Co**
**26 Caxton Street**
**London SW1H 0RJ (GB)**

(43) Date of publication of application:
**05.04.2006 Bulletin 2006/14**

(73) Proprietor: **Tektronix, Inc.**
**Beaverton,**
**Oregon 97077-0001 (US)**

(56) References cited:
**US-A- 5 295 155      US-A1- 2004 078 158**

## Description

BACKGROUND OF THE INVENTION

The present invention relates to testing signal integrity, and more particularly to pattern identification and bit level measurements on repetitive patterns.

For testing signal integrity of certain high speed serial digital signals, such as Serial ATA-II signals defined by an electrical specification (Version 1.0 dated May 19, 2004), differential voltage measurements are specified. The measurements need to be on a signal that has a pre-defined repetitive pattern. The specification generally specifies a methodology that implies the use of a high bandwidth oscilloscope in a waveform database (wfmDB) mode to perform this measurement. The wfmDB mode is the acquisition process of sampling an analog input signal after a trigger event, digitizing each sample of the analog input signal to convert it to digital data, assembling the digital data into a waveform memory, and displaying a waveform that is the accumulation of several acquisitions. The waveform displays not only time and amplitude, but also a count of the number of times a specific sample has been acquired over multiple acquisitions. The value at each point (time after trigger event and amplitude) on the waveform is a counter that reflects such hit intensity. However this specified methodology has some limitations, as indicated below.

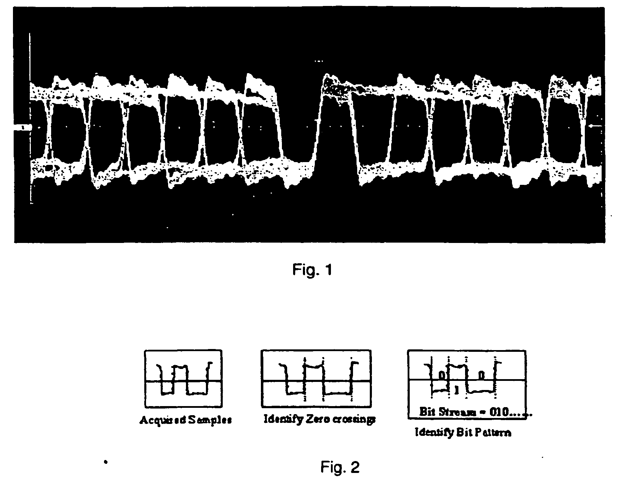

- A pattern trigger is needed to accumulate samples in the wfmDB mode so that the acquired signal has the same pattern. However with the pattern trigger decoding, start and stop of the incoming data is not possible so there is a chance of false triggering, which leads to an incorrect "eye" pattern as shown in Fig. 1.
- Further the trigger bandwidth of the oscilloscope is limited, for example to 1.25 Gbps, and therefore cannot be used for high bandwidth signals, such as the Serial ATA signal having a bandwidth of 1.5 Gbps and 3 Gbps.
- Finally the wfmDB mode is limited to a defined data matrix resolution, such as 500x200. For a 3Gbps signal a unit interval (one clock cycle) is 333.333 ps so the acquisition for a 20-bit pattern is approximately 7 ns. The horizontal resolution of the data matrix is approximately 13 ps. The specification, such as the Serial ATA specification, specifies a region of each bit within which the measurement should be taken, i.e., between 45% and 55% of each bit - the middle of the bit. Thus the number of pixels available in the period 33.3 ps (45% and 55% of a bit) is two, which is not good enough to ascertain the correct voltage level.

What is desired is a better technique for performing pattern identification and bit level measurements on a signal containing repetitive patterns arriving at sporadic time intervals.

US 2004/0078158 A1 discusses a method of determining one or more characteristics of a digital data signal in which regions of an eye diagram that contain information for determining the characteristics of interest are identified. Sufficient samples are then taken to fully construct only the identified regions of the eye diagram without fully constructing the entire eye diagram, and the characteristics of interest are determined using those fully constructed regions.

US 5,295,155 discusses an adaptive regeneration system which reconstructs a signal which is received in the form of a multi-level composite data and clock signal which has been degraded with respect to amplitude and timing. The system compares a plurality of phase delayed local clock signals with the received multi-level composite data and clock signal to identify the one which most closely matches the multi-level composite data and clock signal. The identified local clock signal is then used to regenerate the data.

BRIEF SUMMARY OF THE INVENTION

An aspect of the present invention provides a method of identifying a bit pattern within an input waveform signal representative of a sequence of bits as claimed in claim 1.

In an embodiment, the present invention provides a technique for performing pattern identification and bit level measurements on a signal containing repetitive patterns arriving at sporadic time intervals. An acquired waveform signal is converted into a string of characters representing a bit stream for the acquired waveform. The character string is compared to a pre-defined pattern string to identify corresponding patterns in the character string and to identify a time stamp for each identified pattern. The respective identified patterns are overlaid in a hit matrix to generate a superimposition of all the identified patterns. The columns of the hit matrix corresponding to the center regions of each bit of the identified pattern are used to generate a histogram for each bit from which the appropriate measurements are made.

The objects, advantages and other novel features of the present invention are apparent from the following detailed description when read in conjunction with the appended claims and attached drawing.

BRIEF DESCRIPTION OF THE SEVERAL VIEWS OF THE DRAWING

Fig. 1 is a graphic view of an illegal "eye" diagram according to the prior art.

Fig. 2 is a representative view for converting a waveform signal into a character string according to the present invention.

Fig. 3 is a representative view for pattern matching according to the present invention.

Fig. 4 is a representative view illustrating overlaying of multiple identified patterns in a matrix according to the present invention.

Fig. 5 is a graphic view of an overlaid or superimposed pattern matrix according to the present invention.

Fig. 6 is a representative view illustrating generating a histogram for measurements according to the present invention.

Fig. 7 is a flow diagram view of the process for pattern identification and bit level measurement according to the present invention.

DETAILED DESCRIPTION OF THE INVENTION

The technique described herein enables a user to identify a pre-defined pattern of data within an acquired stream of data. The identified portions of the data pattern are superimposed, one over the other, using a clock recovery and slicing mechanism that prevents erroneous "eye" pattern formations and eliminates the need for pattern triggering at a high bandwidth, i.e., is free from false triggering. The population of the superimposed pattern is substantial enough, and the measurement is based on a sample point resolution, such as up to 4 ps. The core mechanism for this measurement is identifying the pre-defined pattern within the acquired data stream. The technique is divided into the following steps:

    1. Convert the acquired waveform into 1 s and 0s, i.e., a bit stream.
    2. Identify the pre-defined pattern and time stamp from the bit stream.
    3. Overlay or superimpose the identified patterns from the bit stream.
    4. Identify a central region (45%-55%) for each bit on the superimposed pattern.
    5. Perform a voltage level measurement on the bits within the bit stream.

Referring now to Fig. 2, which illustrates how to convert the acquired waveform into 1 s and 0s zero crossing points are found from the acquired signal and a clock is recovered, also from the acquired signal, using a constant clock recovery mechanism. The zero crossing points represent the edges of the signal that are identified for both rising and falling slopes on a voltage differential waveform at a fifty percent (50%) level using a waveform analysis module. The edge information is stored in two arrays: one representing the edge indices and the other representing a corresponding time value relative to the trigger event. The constant clock recovery is done using a least square fit algorithm applied to the transition time intervals with a pre-defined data rate. From the recovered clock data identify a unit interval (one bit time) value. For non-return-to-zero data (NRZ) calculate the number of bits between two zero crossings using the unit interval value and zero crossing points.

$$\text{Number\_of\_bits} = \text{crossing\_time\_difference}/\text{unit\_interval}$$

The signal should have a minimum amplitude to detect the 1 s and 0s. Two threshold voltages may be defined such that, if the signal goes above the maximum threshold, it is a "1" state and, if the signal goes below the minimum threshold, it is a "0" state. Two thresholds are generally used to prevent false state determinations due to noise or other erroneous low-level variations in the signal.

Go to the mid-position between each pair of consecutive zero crossing points and see whether the voltage level is above the maximum threshold or below the minimum threshold. If it is above the maximum threshold, identify this as a "1" state and using the above equation find the number of bits in this region. Now fill an array of characters with that number of 1 s, otherwise with that number of 0s if the voltage level is below the minimum threshold. Complete the above process for all zero crossing point pairs of the input waveform. The result is an array of "0" and "1" characters, i.e., the bit stream of data.

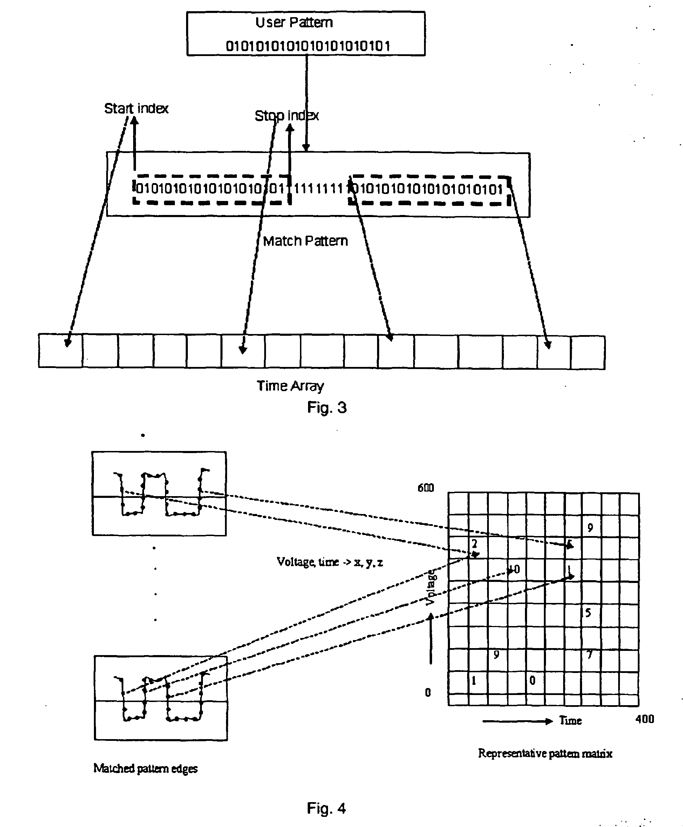

To identify the pattern and time stamp from the bit stream a pattern verification algorithm finds a position of a pre-defined pattern according to the communication standard from the bit stream. The bit stream is converted into a stream string, i.e., transfer the bit stream into a character string. The pre-defined pattern is converted into a pattern string. Find all the patterns in the stream string corresponding to the pattern string, and the identified pattern positions within the stream string represent the time stamp for the identified pattern. Referring now to Fig. 3 the pre-defined pattern is shown having a string of 20 bits alternating between 1 s and 0s. An acquired bit stream is shown that has the same pattern replicated corresponding to a time array. The pattern verification algorithm identifies patterns in the character string corresponding to the pre-defined pattern and their locations in the bit stream.

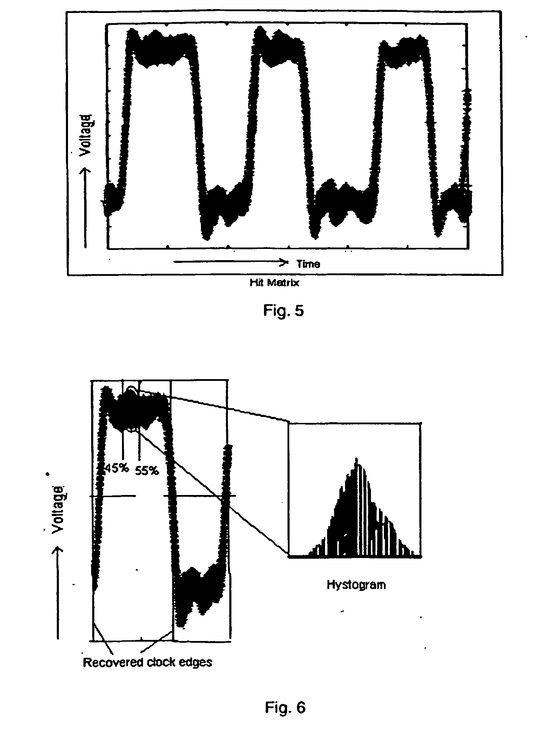

Overlay or superimpose each of the identified patterns having a fixed length in a matrix, as illustrated in Fig. 4. The dimension of the matrix may be configured by a user, and may be scaled up and down according to the signal speed so that there is a sufficient number of hits counted within each bit. For each pre-defined pattern identified in the bit stream take all the waveform data points from the start recovery point (start index) to the end clock recovery point (stop index). Map the pattern (scaled up or down as necessary) into an assigned matrix. Each cell in the matrix is a counter that reflects the number of hits for that cell. The cumulative population provides superimposition for the various occurrences of the pattern in the acquired waveform signal, i.e., identify the position of each data point on the matrix and add one to the hit count for the corresponding cell of the matrix. This may be enhanced by interpolating the acquired sample, i.e., applying a Sinc interpolation function to the acquired sample. A complete overlaid or superimposed pattern matrix is shown in Fig. 5. In the matrix each of the sampled values for the pattern is represented as a three-dimensional vector: X - time scaled within a defined range, such as 0-400; Y - scaled within a defined range, such as 0-600; and Z - population for a given X,Y cell or point in the matrix.

In the matrix generation process the start of the recovered clock is the first column of the matrix. The end of each pattern is the last column of the matrix. The start and end of all bits in the matrix are identified by correcting the calculated edge times using the recovered clock. Then the columns belonging to the central (45%-55%) region of each bit are identified. A histogram of this region is created, as shown in Fig. 6. The histogram represents amplitude values, with the range of amplitude values depending upon the measurement being made. From the created histogram check a condition as prescribed in the pertinent specification, such as the Serial ATA-II document, and calculate all the required parameters for the pre-defined pattern, such as for HFTP, MFTP, LFTP and LBP patterns. The amplitude values depend on the pattern and desired measurement.

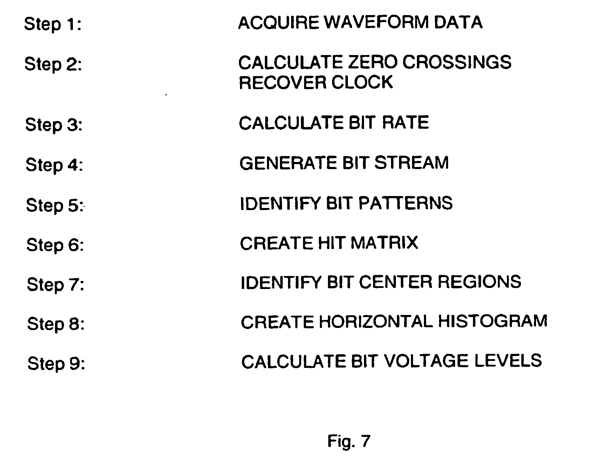

Fig. 7 is a data flow chart of the process described above. Waveform data is input and acquired in step 1. For the acquired waveform data calculate the zero crossings and recover the clock using the constant clock recovery method (step 2). Calculate a bit rate for the input signal (step 3). Identify the number of bits between each consecutive pair of zero crossing points and generate the bit stream sequence of 1 s and 0s (step 4). Identify the start positions of each instance of the pre-defined pattern within the bit stream sequence so that there is no overlap between consecutive patterns (step 5). Create a hit matrix using all identified patterns (step 6). Identify a center region for each bit from the hit matrix (step 7). Create a horizontal histogram for each center region (step 8). Calculate the required voltage levels as specified in the pertinent signal specification (step 9).

The above technique automates a testing procedure and is extensible to new patterns that evolve in future versions of a signal specification.

Thus the above described technique identifies bit patterns in a high speed serial digital signal by converting the high speed serial digital signal to a bit stream, identifying a pre-defined pattern and time stamp within the bit stream, overlaying or superimposing consecutive patterns identified within the bit stream in a matrix, identifying a central region for each bit in the matrix, and performing pertinent voltage measurements within the central region of each bit to obtain bit levels.

## Claims

1. A method of identifying a bit pattern within an input waveform signal representative of a sequence of bits, the method comprising the steps of:

   converting waveform data acquired from the input waveform signal into a bit stream sequence;
   identifying from the bit stream sequence occurrences of a pre-defined pattern of bits;
   overlaying portions of the waveform data corresponding to identified occurrences of the pre-defined pattern of bits to form a superimposed pattern waveform; and
   for each bit of the pre-defined pattern of bits identifying a central region within the superimposed pattern waveform for performing measurements.

2. The method as recited in claim 1 further comprising the step of performing voltage measurements within the central region of each bit.

3. The method as recited in claim 1 or 2, wherein the converting step comprises the steps of:

   finding zero crossing points from the waveform data;
   recovering a clock using a constant clock recovery mechanism;
   identifying from the clock a unit interval value;

calculating a number of bits between consecutive zero crossing points using the unit interval value;
determining a state of the waveform data at a mid-point between zero crossing points; and
providing the bit stream sequence from the succession of states of the waveform data.

4. The method as recited in any preceding claim wherein the pre-defined pattern of bits identifying step comprises the steps of:

converting the bit stream sequence into a character string;
converting the pre-defined pattern of bits into a pattern string;
finding one or more of the pattern strings within the character string, the relative positions of each found pattern string representing a time stamp for each found pattern string; and
storing the found patterns strings from the bit stream sequence as the identified pre-defined patterns of bits.

5. The method as recited in claim 4 wherein the overlaying step comprises the steps of:

identifying a start clock recovery point for each stored found pattern string; and
mapping the pre-defined patterns of bits for each found pattern string from the waveform data into a hit matrix to produce the superimposed pattern waveform.

6. The method as recited in any preceding claim wherein the central region identifying step comprises the steps of:

identifying a start and an end for each bit in the superimposed pattern waveform;
identifying columns of waveform data in the hit matrix belonging to the central region for each bit; and
creating a histogram for each bit from the waveform data within the respective central regions.

7. Pattern identification apparatus arranged to perform all the steps of the method as recited in any preceding claim.


**Patentansprüche**

1. Verfahren zum Identifizieren eines Bitmusters innerhalb eines Eingangswellenformsignals, das eine Sequenz von Bits darstellt, wobei das Verfahren die Schritte umfasst:

Umwandeln von Wellenformdaten, die vom Eingangswellenformsignal erfasst werden, in eine Bitstromsequenz;
Identifizieren von Vorkommnissen eines vordefinierten Musters von Bits aus der Bitstromsequenz;
Überlagern von Teilen der Wellenformdaten, die identifizierten Vorkommnissen des vordefinierten Musters von Bits entsprechen, um eine Wellenform mit überlagertem Muster zu bilden; und
für jedes Bit des vordefinierten Musters von Bits Identifizieren eines zentralen Bereichs innerhalb der Wellenform mit überlagertem Muster zum Durchführen von Messungen.

2. Verfahren nach Anspruch 1, welches ferner den Schritt des Durchführens von Spannungsmessungen innerhalb des zentralen Bereichs jedes Bits umfasst.

3. Verfahren nach Anspruch 1 oder 2, wobei der Umwandlungsschritt die folgenden Schritte umfasst:

Auffinden von Nulldurchgangspunkten aus den Wellenformdaten;
Wiedergewinnen eines Takts unter Verwendung eines Konstanttakt-Wiedergewinnungsmechanismus;
Identifizieren eines Einheitsintervallwerts aus dem Takt;
Berechnen einer Anzahl von Bits zwischen aufeinander folgenden Nulldurchgangspunkten unter Verwendung des Einheitsintervallwerts;
Bestimmen eines Zustandes der Wellenformdaten an einem Mittelpunkt zwischen Nulldurchgangspunkten; und
Liefern der Bitstromsequenz von der Folge von Zuständen der Wellenformdaten.

4. Verfahren nach einem vorangehenden Anspruch, wobei der Schritt der Identifikation des vordefinierten Musters von Bits die folgenden Schritte umfasst:

Umwandeln der Bitstromsequenz in eine Zeichenkette;
Umwandeln des vordefinierten Musters von Bits in eine Musterkette;

Auffinden von einer oder mehreren der Musterketten innerhalb der Zeichenkette, wobei die relativen Positionen von jeder gefundenen Musterkette einen Zeitstempel für jede gefundene Musterkette darstellen; und Speichern der gefundenen Musterketten aus der Bitstromsequenz als identifizierte vordefinierte Muster von Bits.

**5.** Verfahren nach Anspruch 4, wobei der Überlagerungsschritt die folgenden Schritte umfasst:

Identifizieren eines Taktwiedergewinnungs-Startpunkts für jede gespeicherte gefundene Musterkette; und Abbilden der vordefinierten Muster von Bits für jede gefundene Musterkette von den Wellenformdaten in eine Treffermatrix, um die Wellenform mit überlagertem Muster zu erzeugen.

**6.** Verfahren nach einem vorangehenden Anspruch, wobei der Schritt der Identifikation des zentralen Bereichs die folgenden Schritte umfasst:

Identifizieren eines Starts und eines Endes für jedes Bit in der Wellenform mit überlagertem Muster; Identifizieren von Spalten von Wellenformdaten in der Treffermatrix, die zum zentralen Bereich gehören, für jedes Bit; und Erzeugen eines Histogramms für jedes Bit aus den Wellenformdaten innerhalb der jeweiligen zentralen Bereiche.

**7.** Musteridentifikationsvorrichtung, die so beschaffen ist, dass sie alle Schritte des Verfahrens nach einem vorangehenden Anspruch durchführt.

## Revendications

**1.** Procédé pour identifier un motif de bits dans un signal de forme d'onde entré représentant une séquence de bits, le procédé comportant les étapes consistant à :

convertir les données de forme d'onde acquises à partir du signal de forme d'ondes entré en une séquence de flux de bits ; identifier à partir de la séquence de flux de bits les apparitions d'un motif de bits prédéfini ; recouvrir des partiels de données de forme d'onde correspondant aux apparitions identifiées du motif de bits prédéfini pour former une forme d'onde de motif superposée ; et pour chaque bit du motif prédéfini de bits, identifie une région centrale à l'intérieur de la forme d'onde de motif superposée pour effectuer des mesures.

**2.** Procédé selon la revendication 1, comportant en outre l'étape consistant à effectuer des mesures de tension dans la région centrale de chaque bit.

**3.** Procédé selon la revendication 1 ou 2, dans lequel l'étape de conversion comporte les étapes consistantes à :

trouver les points de passage par zéro à partir des données de la forme d'onde ; récupérer une horloge en utilisant un mécanisme de récupération d'horloge constant ; identifier à partir de l'horloge une valeur d'intervalle d'unité ; calculer un nombre de bits entre des points de passage par zéro consécutifs en utilisant la valeur d'intervalle d'unité ; déterminer un état des données de la forme d'ondes en un point médian entre des points de passage par zéro ; et délivrer la séquence de flux de bits à partir de la succession d'états de données de la forme d'onde.

**4.** Procédé selon l'une quelconque des revendications précédentes, dans lequel l'étape identifiant le motif prédéfini de bits comporte les étapes consistant à :

convertir la séquence de flux de bits en une chaîne de caractères ; convertir le motif prédéfini de bits en une chaîne de motifs ; trouver une ou plusieurs chaînes de motifs à l'intérieur de la chaîne de caractères, les positions relatives de chaque chaîne de motifs trouvée représentant un horodateur pour chaque chaîne de motifs trouvée ; et mémoriser les chaînes de motifs trouvées à partir de la séquence de flux de bits en tant que motifs prédéfinis de bits identifiés.

**5.** Procédé selon la revendication 4, dans lequel l'étape de recouvrement comporte les étapes consistant à :

identifier un point de récupération d'horloge de départ pour chaque chaîne de motifs trouvée mémorisée ; et mapper les motifs prédéfinis de bits pour chaque chaîne de motifs trouvée à partir des données de forme d'onde dans une matrice cachée pour produire la forme d'onde de motifs superposée.

**6.** Procédé selon l'une quelconque des revendications précédentes dans lequel l'étape d'identification de région centrale comporte les étapes consistant à :

identifier un commencement et une fin pour chaque bit dans la forme d'onde de motifs superposée ; identifier les colonnes des données de forme d'onde dans la matrice cachée appartenant à la région centrale pour chaque bit ; et créer un histogramme pour chaque bit à partir des données de forme d'onde à l'intérieur des régions centrales respectives.

**7.** Dispositif d'identification de motif agencé pour effectuer toutes les étapes du procédé selon l'une quelconque des revendications précédentes.

Fig. 1

Acquired Samples       Identify Zero crossings       Bit Stream = 010....

Identify Bit Pattern

Fig. 2

User Pattern

010101010101010101010101

Start index

Stop index

010101010101010101 01 11111111 010101010101010101010101

Match Pattern

Time Array

Fig. 3

600

Voltage, time -> x, y, z

Voltage

| | | | | | | | | 9 | |
| 2 | | | | | | | | | |
| | | | | | 0 | | | 1 | |
| | | | | | | | | 5 | |
| | 9 | | | | | 7 | | |
| 1 | | | 0 | | | | | |

0

Time       400

Matched pattern edges

Representative pattern matrix

Fig. 4

Hit Matrix

Fig. 5

45% 55%

Hystogram

Recovered clock edges

Fig. 6

Step 1:               ACQUIRE WAVEFORM DATA

Step 2:               CALCULATE ZERO CROSSINGS
RECOVER CLOCK

Step 3:               CALCULATE BIT RATE

Step 4:               GENERATE BIT STREAM

Step 5:               IDENTIFY BIT PATTERNS

Step 6:               CREATE HIT MATRIX

Step 7:               IDENTIFY BIT CENTER REGIONS

Step 8:               CREATE HORIZONTAL HISTOGRAM

Step 9:               CALCULATE BIT VOLTAGE LEVELS

Fig. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20040078158 A1

- US 5295155 A